# FASCICULE DE BREVET EUROPEEN

(11) **EP 0 925 553 B1**
(45) Date de publication et mention de la délivrance du brevet: **29.08.2001**
(21) Numéro de dépôt: 97938972.3
(22) Date de dépôt: 02.09.1997
(51) Int. Cl.: G06K 19/077

(54) **PROCEDE DE FABRICATION D'UN ENSEMBLE DE MODULES ELECTRONIQUES POUR CARTES A MEMOIRE SANS CONTACT**
VERFAHREN ZUR HERSTELLUNG EINER ANORDNUNG VON ELEKTRONISCHEN MODULEN FÜR KONTAKTLOSE SPEICHERKARTEN
METHOD FOR MAKING AN ASSEMBLY OF ELECTRONIC MODULES FOR CONTACTLESS MEMORY CARDS

(30) Priorité: 12.09.1996 FR 9611147
(43) Date de publication de la demande: 30.06.1999
(73) Titulaire: SCHLUMBERGER Systèmes, 92120 Montrouge (FR)
(72) Inventeur: ROSE, René, F-30000 Nimes (FR)
(86) Numéro de dépôt international: FR9701549
(87) Numéro de publication internationale: WO9811507

(56) Documents cités:
- EP-A- 0 380 426
- EP-A- 0 595 549
- EP-A- 0 682 321
- EP-A- 0 706 152
- DE-A- 4 337 921
- FR-A- 2 684 471
- JP-A- 8 216 571
- PATENT ABSTRACTS OF JAPAN vol. 96, no. 4, 30 avril 1996 & JP 07 321438 A (SONY CORP.), août 1995,

## Description

La présente invention concerne un procédé de fabrication d'un ensemble de modules électroniques pour cartes à mémoire électronique aptes à échanger, sans contact électrique, des informations avec un dispositif de lecture.

L'invention trouve une application avantageuse dans le domaine de la fabrication des cartes sans contact, notamment celles pouvant être utilisées comme titres de transport, comme badges d'accès à des locaux protégés, ou encore comme moyens de paiement de communications téléphoniques. Plus particulièrement, l'invention s'adresse aux cartes sans contact devant fonctionner dans une faible distance d'interaction avec le dispositif de lecture ("close coupling" en anglo-saxon).

L'échange d'informations entre une carte sans contact et le dispositif de lecture auquel elle est associée s'effectue, de manière très générale, par couplage électromagnétique à distance entre une première antenne logée dans la carte sans contact et une deuxième antenne située dans ledit dispositif de lecture. La carte est munie, par ailleurs, d'un circuit intégré connecté à ladite première antenne et comportant une pastille semi-conductrice, ou puce, qui contient, entre autres, une mémoire dans laquelle sont stockées les informations à fournir au dispositif de lecture, ainsi que des moyens, un microprocesseur par exemple, prévus pour élaborer les informations à émettre et traiter les informations reçues.

Dans le cas de cartes sans contact simples, l'antenne de couplage et le circuit intégré sont le plus souvent noyés dans le corps de carte, tandis que, s'agissant de cartes dites hybrides, pouvant également fonctionner avec contact, le circuit intégré est placé dans ledit corps de carte de sorte que des plages de contact aménagées sur le circuit affleurent à la surface d'une des faces du corps de carte.

On connaît aujourd'hui un certain nombre de procédés permettant de fabriquer des cartes sans contact telles qu'elles viennent d'être décrites. Cependant, ces procédés connus ne sont pas sans présenter quelques inconvénients.

Tout d'abord, une première difficulté réside dans la nécessité de réaliser un logement destiné à accueillir l'antenne de la carte. Pour cela, on peut simplement usiner une gorge annulaire dans la masse d'une feuille d'un matériau plastique comme du PVC. Outre l'usinage, coûteux en temps, ce procédé exige également, après mise en place de l'antenne, des injections de résine dans le logement afin de donner une consistance mécanique à l'ensemble.

Si le logement de l'antenne n'est pas usiné, il peut être obtenu par laminage d'au moins trois éléments, à savoir une feuille plane servant de base, un cadre en une ou deux parties, et un noyau central. Cet assemblage nécessite plusieurs opérations et conduit à un flux de fabrication carte à carte de faible productivité.

Un autre procédé connu consiste à surmouler l'antenne et la pastille semi-conductrice dans une feuille de résine, polyuréthanne par exemple, puis de laminer cette feuille entre deux feuilles de PVC. L'inconvénient de ce procédé est d'aboutir à une structure hétérogène du fait de l'utilisation de matériaux plastiques différents.

Une deuxième difficulté rencontrée avec les procédés de fabrication actuels est qu'ils font tous appel à un laminage à froid ou, du moins, à basse température. En effet, dans le cas par exemple de structures inhomogènes telles que celles mentionnées plus haut, les matériaux utilisés ont des points de fusion différents, ce qui impose de travailler à la température la plus basse acceptée par l'ensemble des constituants. Cependant, les adhésifs basse température (60-70°) ne donnent pas toujours de bons résultats, la tenue mécanique des couches étant grandement amoindrie.

On connaît par ailleurs un document EP-A2-0 595 549 qui décrit un procédé de fabrication d'étiquettes électroniques dans lequel une antenne en spirale est réalisée sur une bande de polyester, deux bornes de l'antenne étant intérieures aux spires, et dans lequel un circuit intégré est connecté auxdites bornes par l'intermédiaire d'un adhésif électriquement conducteur préalablement déposé sur lesdites bornes.

Aussi, le problème technique à résoudre par l'objet de la présente invention est de proposer un procédé qui permettrait de réaliser des cartes sans contact selon une mise en oeuvre qui se distinguerait des procédés connus par sa simplicité et son faible coût, tout en assurant une excellente tenue mécanique des différents composants de la carte.

La solution au problème technique posé consiste, selon la présente invention, en un procédé de fabrication d'un ensemble de modules électroniques pour cartes à mémoire électronique aptes à échanger, sans contact électrique, des informations avec un dispositif de lecture, lesdites cartes comportant, chacune, une antenne de couplage avec ledit dispositif de lecture et un circuit intégré connecté à ladite antenne, ledit procédé comportant les étapes suivantes :
a) réalisation, sur un substrat isolant en feuille, d'une pluralité de groupes régulièrement répartis de trous traversants, chaque groupe de trous étant associé à un module électronique, et lesdits trous traversants étant destinés à être remplis d'un matériau conducteur afin d'assurer la continuité électrique entre une première et une deuxième faces du substrat isolant, prévues pour recevoir respectivement, pour chaque module électronique, d'une part, des contacts électriques de liaison avec un connecteur extérieur et, d'autre part, des motifs d'interconnexion sur lesquels le circuit intégré à protubérances est destiné à être monté,
b) une première sérigraphie consistant à réaliser lesdits contacts électriques par dépôt d'une encre conductrice sur la première face du substrat isolant en feuille, lesdits trous étant partiellement remplis de ladite encre,
c) plusieurs sérigraphies consistant à réaliser par au moins un dépôt d'une encre conductrice sur la deuxième face du substrat isolant en feuille, d'une part, lesdits motifs d'interconnexion, lesdits trous traversants étant complètement remplis par ladite encre, et, d'autre part, lesdites antennes de couplage sous forme de spire délimitées, chacune, par une première et une deuxième bornes d'antenne, intérieures auxdites spires,
d) montage d'un circuit intégré à protubérances sur les motifs d'interconnexion et les première et deuxième bornes intérieures d'antenne,
e) découpage de ladite feuille de substrat isolant en modules électroniques formés, chacun, par l'ensemble constitué par lesdits contacts électriques, ladite antenne de couplage et le circuit intégré à protubérances.

Ainsi, le procédé selon l'invention permet d'obtenir de manière très simple et peu coûteuse un grand nombre de modules électroniques pour cartes sans contact simples, par exemple une centaine sur une feuille de 152, 4 mm (6 pouces) de côté.

Les modules électroniques ainsi réalisés peuvent ensuite être intégrés aux corps de cartes selon des techniques d'encartage usuelles dans le domaine des cartes à mémoire électronique, par exemple par insertion et collage dans une cavité usinée ou moulée dans le corps de carte, ou encore par moulage du corps de carte, le module électronique étant présent dans le moule.

Le procédé de l'invention présente également l'avantage de se prêter facilement à toute modification de gabarit de l'antenne de couplage. De même, il est possible d'utiliser des circuits intégrés de toutes dimensions, contrairement au procédé connu sous le terme anglo-saxon de "coil on chip" (bobine sur la puce) pour lequel la taille du circuit intégré est fonction de la dimension de l'antenne.

On notera également que le procédé conforme à l'invention met en oeuvre des circuits intégrés à protubérances, selon une technologie de montage et d'interconnexion des circuits intégrés communément désignée sous le vocable anglo-saxon de "flip chip".

Cette technique consiste à former sur les métallisations d'entrée/sortie du circuit intégré des protubérances constituées d'un ou plusieurs matériaux conducteurs de l'électricité. Après montage sur le substrat, ces protubérances assurent les fonctions de liaison électrique, de maintien mécanique et de conduction thermique. Les avantages de cette technologie sont :
- diminution du nombre d'opérations d'assemblage,
- suppression des fils de câblage qui sont fragiles,
- une seule soudure par métallisation d'entrée/sortie,
- une amélioration du niveau de fiabilité. Le procédé de fabrication selon l'invention est prévu pour la réalisation de cartes sans contact hybrides.

Comme cela a déjà été mentionné plus haut, une technique connue de réalisation des cartes à mémoire électronique consiste à placer les modules dans un moule dont les empreintes définissent les cartes aux normes ISO et d'injecter un matériau thermoplastique. Ce matériau thermoplastique peut être un ABS, un polycarbonate ou un matériau de la famille du polyester. Dans ce cas, le substrat isolant en feuille sera choisi de manière à créer des liaisons moléculaires au cours de l'injection, entre ledit substrat et le matériau thermoplastique injecté.

De même une autre technique connue de réalisation des cartes est celle de l'assemblage des modules dans les corps de carte auxquels ils sont destinés, consistant à aménager, par moulage ou usinage, une cavité dans lesdits corps de carte et à insérer les modules dans lesdites cavités. A cet effet, il est prévu, selon la présente invention, que, entre l'étape c) de deuxième sérigraphie et l'étape d) de montage, est intercalée une étape de dépôt autour desdits motifs d'interconnexion, d'un matériau d'assemblage des modules électroniques dans des corps de carte à mémoire électronique. Le dépôt peut être réalisé par sérigraphie, collage ou tout autre procédé.

Selon des variantes de l'invention, ledit matériau d'assemblage est une résine époxy réactivable thermiquement, une colle fusible ("hot melt") ou encore un thermoplastique pour soudure par ultra-sons. Dans ce dernier cas, les dimensions du motif doivent permettre la concentration suffisante de l'énergie ultra-sonore.

La description qui va suivre en regard des dessins annexés, donnés à titre d'exemples non limitatifs, fera bien comprendre en quoi consiste l'invention et comment elle peut être réalisée.

Les figures 1a à 1d sont des vues de dessus illustrant les différentes étapes d'un procédé de fabrication de modules électroniques pour cartes sans contact simples.

La figure 2 est une vue de dessus montrant une antenne de couplage formée de deux demi-antennes sur chaque face d'une feuille de substrat isolant.

La figure 3 est une vue de dessus d'une feuille de substrat isolant perforée de trous traversants pour la mise en oeuvre d'un procédé de fabrication de modules électroniques pour cartes sans contact hybrides.

La figure 4 est une vue de dessus de la première face de la feuille de la figure 3 après sérigraphie des contacts électriques.

La figure 5 est une vue de dessus d'un contact électrique de la figure 4.

La figure 6 est une vue de dessus d'un motif d'interconnexion et d'une antenne de couplage sérigraphiés sur la deuxième face de la feuille de substrat isolant de la figure 3.

La figure 7 est une vue de dessous d'un module électronique pour cartes sans contact hybrides.

La figure 8a est une vue de côté d'un circuit intégré à protubérances.

La figure 8b est une vue de côté du circuit intégré de la figure 8a monté sur la deuxième face du substrat isolant de la figure 3.

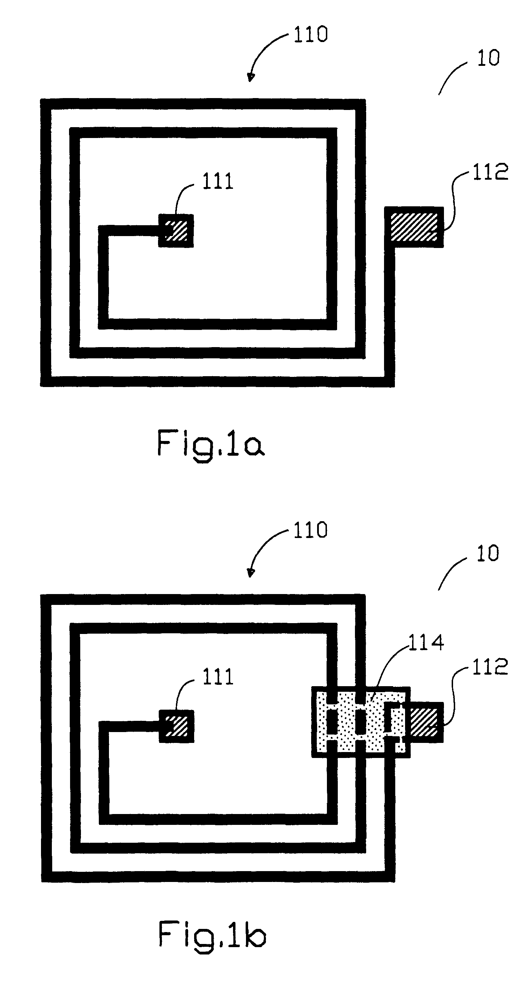

Un procédé de fabrication d'un ensemble de modules électroniques pour cartes sans contact simple va maintenant être décrit en regard des figures 1a à 1d. Ces cartes sont aptes à échanger, sans contact électrique, des informations avec un dispositif de lecture, non représenté. A cet effet, elles comportent, chacune, une antenne 110 de couplage avec ledit dispositif de lecture et un circuit intégré 30 connecté à ladite antenne 110.

Ledit procédé comporte une première étape de sérigraphie qui consiste à réaliser sur un substrat isolant 10 en feuille, une pluralité d'antennes 110 de couplage, telles que celle montrée à la figure 1a, régulièrement réparties, par dépôt d'une encre conductrice sur une face de ladite feuille 10 sous forme de spires délimitées, à chaque extrémité, par une borne 111 intérieure aux spires, dite première borne intérieure d'antenne, et une borne 112 extérieure aux spires.

Bien entendu, le matériau isolant constituant la feuille 10 de substrat devra être compatible avec la température de cuisson des encres qui seront utilisées par les sérigraphies et avec le type de circuits intégrés à protubérances choisis pour équiper les modules électroniques et aussi au mode de réalisation de la carte. De manière non limitative, les matériaux suivants sont parmi ceux pouvant convenir pour réaliser la feuille 10 de substrat isolant : tissu de verre imprégné époxy, polycarbonate, polyester, polyimide, polyacrylate, polyétherimide.

A titre indicatif, les spires de l'antenne 110 de couplage peuvent être sérigraphiées avec une encre conductrice chargée argent, ou encore cuivre ou or, sur une épaisseur de 25 à 40 µm.

La deuxième étape du procédé, objet de l'invention, consiste conformément à la figure 1b, à sérigraphier, sur chaque antenne 110 de couplage, un pont 114 d'isolement par dépôt d'une encre diélectrique sous forme d'une bande isolante s'étendant sur les spires de l'antenne entre la première borne intérieure 111 d'antenne et la borne extérieure 112. Ladite encre diélectrique est, par exemple, une encre polymère chargée alumine déposée sur une épaisseur de 25 à 40 µm.

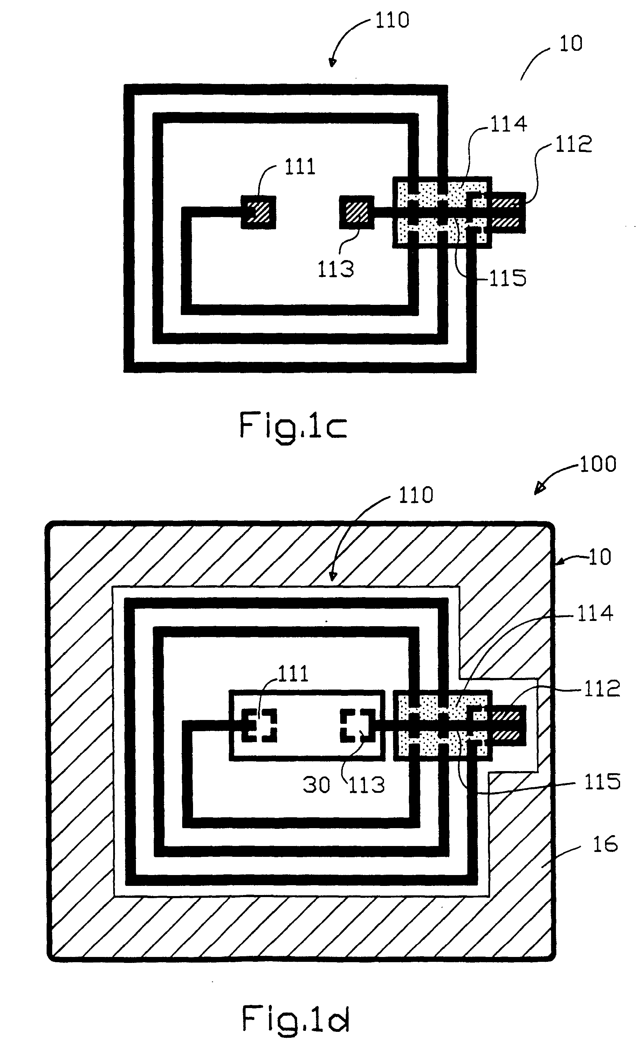

La figure 1c illustre une troisième étape du procédé au cours de laquelle un conducteur 115 de fermeture est sérigraphié par dépôt d'une encre conductrice sous forme d'une piste reliant, par l'intermédiaire dudit pont 114 d'isolement, la borne extérieure 112 à une deuxième borne intérieure 113 de l'antenne 110. L'encre conductrice utilisée pour réaliser ledit conducteur 115 de fermeture peut, naturellement, être identique à l'encre conductrice constituant l'antenne 110.

Ensuite, dans une quatrième étape, un circuit intégré 30 du type à protubérances est monté sur les première 111 et deuxième 113 bornes d'antenne, conformément à la figure 1d selon la méthode de "flip chip" visée dans le préambule de la description, les protubérances étant directement en contact avec les bornes d'antenne.

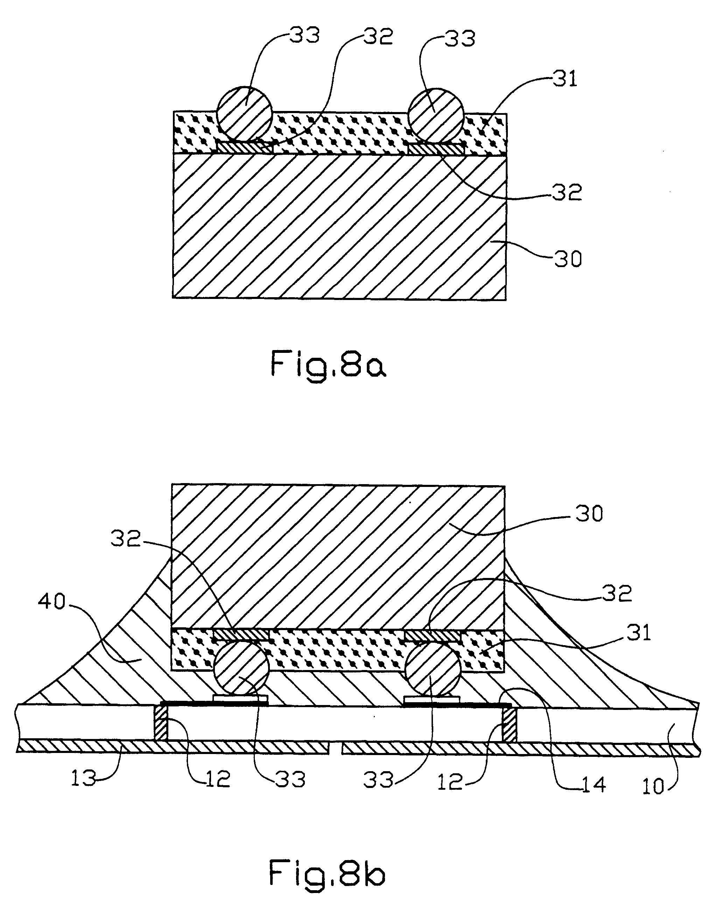

La façon dont sont constitués lesdits circuits intégrés à protubérances ainsi que la manière dont ils sont montés sur lesdites bornes seront décrites en détail plus loin en relation avec les figures 8a et 8b.

Enfin, comme le montre également la figure 1d, la feuille 120 de substrat isolant est découpée en une pluralité de modules électroniques 100 formés, chacun, de l'ensemble constitué par l'antenne 110 de couplage et le circuit intégré 30 à protubérances.

On peut aussi prévoir d'imprimer sur la même face de la feuille 10, par procédé sérigraphique, collage ou tout autre procédé, un matériau d'assemblage des modules électroniques 100 dans une cavité aménagée dans les corps de cartes à mémoire électronique. Ainsi que l'indique la figure 1d, ledit matériau 16 d'assemblage est déposé autour de l'antenne 110 de couplage. La nature du matériau lui-même peut être une résine époxy réactivable thermiquement ou une colle fusible ("hot melt"). Un thermoplastique peut aussi être imprimé, les dimensions de l'antenne étant déterminées afin de définir un concentrateur d'énergie suffisant pour l'assemblage par ultra-sons des modules dans les corps de cartes.

Si la technique du moulage des cartes avec leur module électronique est retenue, le matériau du substrat du module est, de préférence, un thermoplastique apte à favoriser la création de liaisons moléculaires entre le substrat isolant et le corps de carte.

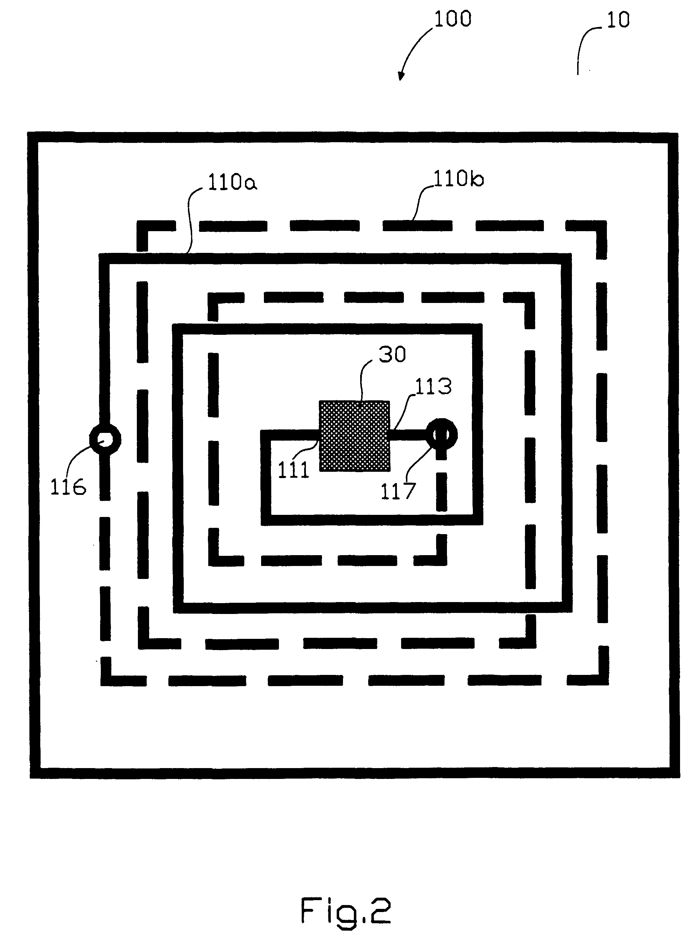

La figure 2 montre une variante d'exécution dans laquelle chaque antenne 110 de couplage est réalisée en deux demi-antennes 110a, 110b par dépôt de l'encre conductrice sur chaque face de la feuille 10 de substrat isolant, les deux demi-antennes étant reliées par des trous traversants conducteurs 116, 117.

Va être maintenant décrit un procédé de fabrication d'un ensemble de modules électroniques pour cartes à mémoire hybrides, c'est-à-dire aptes à échanger avec ou sans contact électrique, des informations avec un dispositif de lecture.

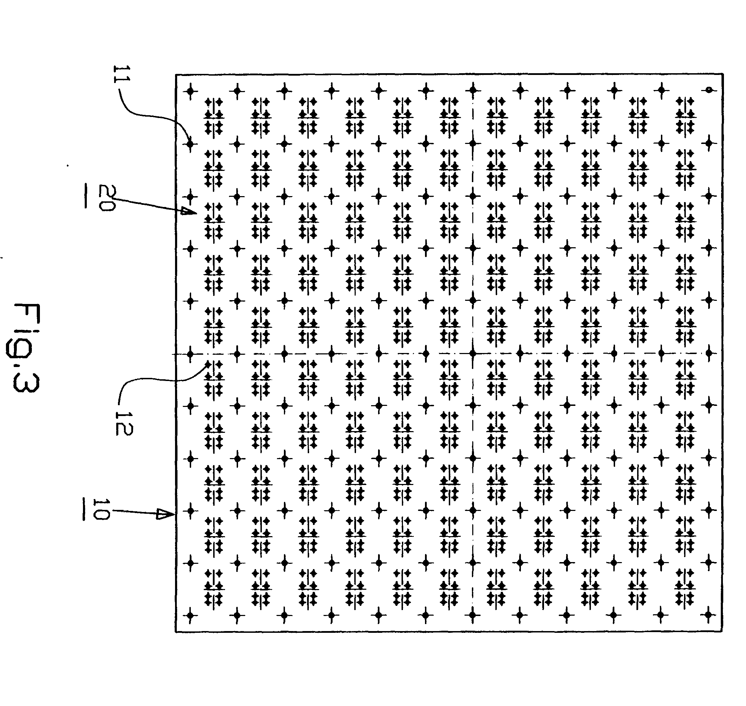

Comme l'indique la figure 3, on fournit d'abord une feuille 10 de substrat isolant de grande dimension par exemple de 152,4 mm de côté pour la réalisation de 100 modules. La feuille 10 a une épaisseur comprise entre 0,1 et 0,2 mm et présente les mêmes caractéristiques de compatibilité que celles mentionnées précédemment en référence aux modules électroniques pour cartes sans contact simples.

Conformément à la figure 3, le substrat isolant est percé de trous traversant l'épaisseur de la feuille 10. Cet usinage est réalisé par une machine programmable, de préférence sur une pile de feuilles serrées entre deux plaques de métal.

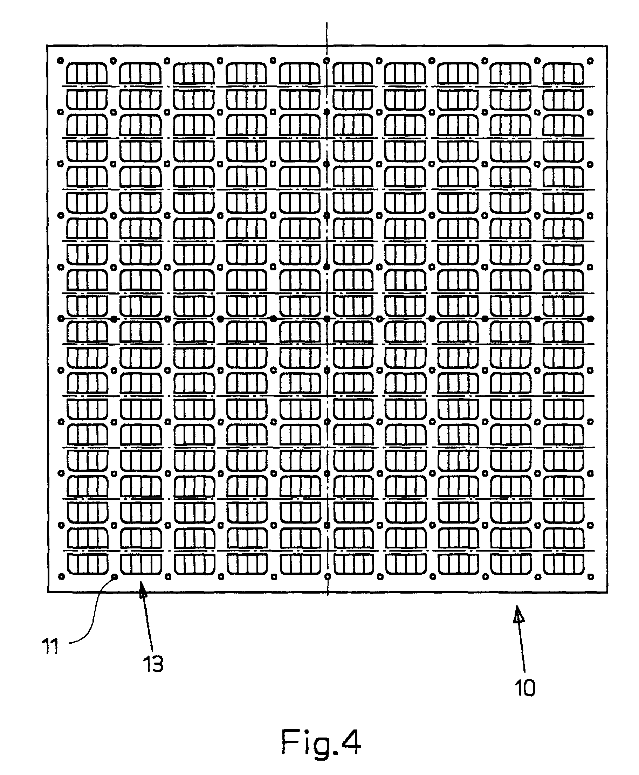

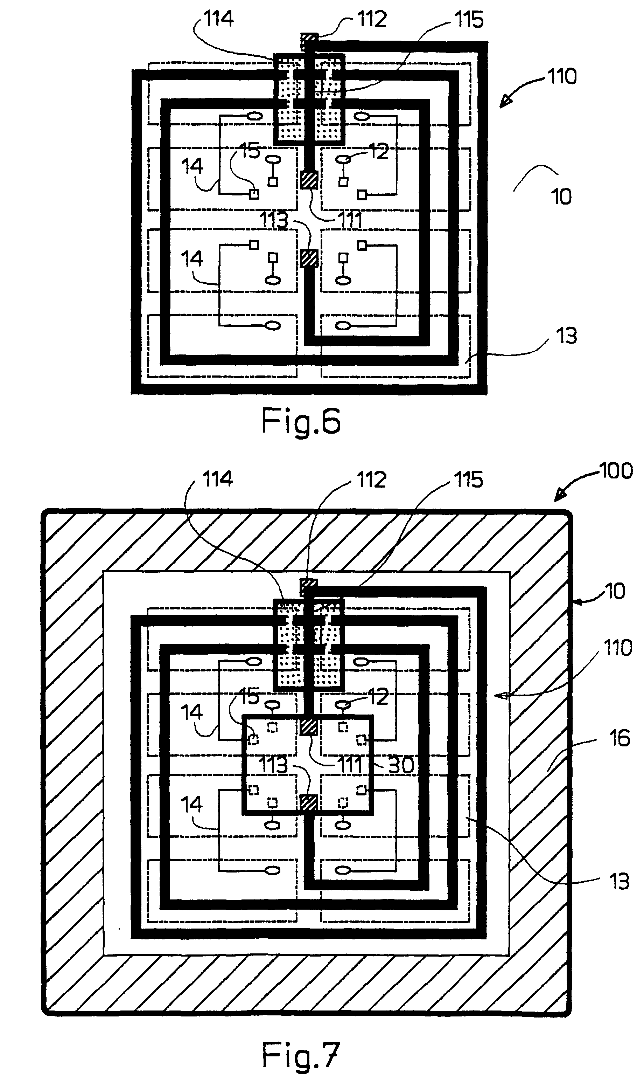

Deux séries de trous sont usinées. D'une part, des trous 11 de grand diamètre ont pour fonction de servir de centrage et d'indexation. D'autre part, des trous 12 de plus petit diamètre, agencés en groupes 20 régulièrement répartis, chaque groupe 20 étant associé à un module électronique. Les trous 12 sont destinés, au cours du déroulement du procédé, à être remplis d'un matériau conducteur afin d'assurer la continuité électrique entre une première face (figure 4) et une deuxième face (figures 6 et 7) du substrat isolant.

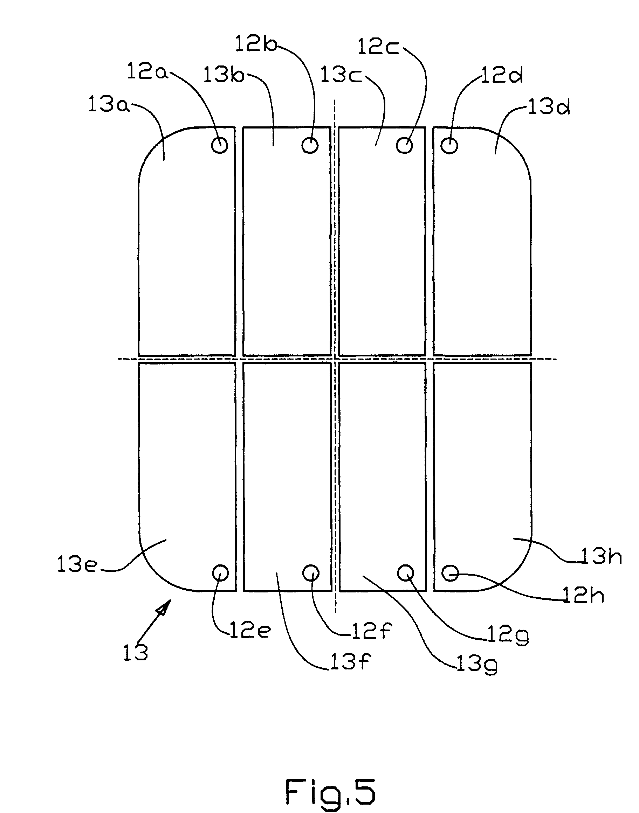

On peut voir sur la figure 4 que la première face de la feuille 10 de substrat est prévue pour recevoir, pour chaque module électronique, des contacts électriques 13 qui, comme le montre mieux la figure 5, comprennent une pluralité, ici de huit plages 13a à 13h, chacune en regard d'un trou traversant 12a à 12h. Lesdits contacts électriques 13 sont réalisés par une première sérigraphie à l'aide d'une encre conductrice, de préférence une encre conductrice chargée argent qui est la technique la plus économique. Lors de cette opération, les trous traversants 12 sont partiellement remplis d'encre conductrice.

Les contacts électriques 13 ainsi obtenus sont dessinés de manière à pouvoir entrer en liaison avec des connecteurs standards de lecteurs de cartes à mémoire électronique. Lesdits contacts 13 sont donc communs aux différentes applications des modules. De ce fait, les feuilles 10 de substrat peuvent être sérigraphiées sur leur première face à une grande échelle, puis stockées après traitement thermique dans l'attente de recevoir sur leur deuxième face une seconde sérigraphie spécifique à un type donné de circuits intégrés.

A moins d'utiliser une encre polymère chargée or ou or/métallo-organique, les contacts électriques 13 sérigraphiés en encre polymère chargée argent peuvent être rechargés par des dépôts métalliques, par exemple nickel puis or, ceci à des fins esthétiques et/ou de compatibilité avec la nature des protubérances des circuits intégrés. La technique utilisée pour recharger les contacts 13 est, par exemple, le procédé dit "electroless" à déplacement d'ions.

Les écrans de sérigraphie sont réalisés à partir de toiles en acier inoxydable d'un nombre de mailles compris entre 200 et 400 mesh.

La figure 6 montre la deuxième face de la feuille 10 isolante sur laquelle ont été imprimés, dans une deuxième étape de sérigraphie, des motifs 14 d'interconnexion dont une fonction est de relier électriquement au débouché des trous traversants 12 sur ladite deuxième face des plots 15 de raccordement disposés de manière à recevoir les protubérances des circuits intégrés. On obtient ainsi que chaque protubérance est en liaison électrique avec une et une seule des plages des contacts électriques 13. Il est clair que ce type d'interconnexions est particulier à un circuit intégré donné.

De préférence en cours de la même opération de sérigraphie, les antennes 110 de couplage sont déposées sous forme de spires délimitées par une première borne 111 d'antenne intérieure aux spires et une borne extérieure 112, de la même manière que pour les modules des cartes sans contact simples. Puis, dans une troisième sérigraphie, on réalise sur chaque antenne 110 un pont 114 d'isolement par dépôt d'une bande isolante entre la première borne intérieure 111 et la borne extérieure 112. Ensuite, le conducteur 115 de fermeture est déposé par sérigraphie d'une encre conductrice sous forme d'une piste reliant la borne extérieure 112 à une deuxième borne intérieure 113 de l'antenne.

De même que pour les cartes sans contact simples, on peut prévoir d'imprimer sur ladite deuxième face, par procédé sérigraphique, collage ou tout autre procédé, un matériau d'assemblage des modules électroniques dans une cavité aménagée dans les corps de cartes à mémoire électronique. Ainsi que le montre la figure 7, ledit matériau 16 d'assemblage est déposé en anneau autour des motifs 14 d'interconnexion et de l'antenne 110 de couplage.

Enfin, dans une dernière étape du procédé, objet de l'invention, les circuits intégrés à protubérances sont montés sur les plots 15 de raccordement des motifs 14 d'interconnexion respectifs. Pour cela, les circuits intégrés auront été préparés d'une manière également applicable aux cartes sans contact simples, qui va maintenant être décrite en regard des figures 8a et 8b.

Alors que les circuits 30 sont encore réunis sur une plaque ("wafer"), une couche 31 de diélectrique est déposée par sérigraphie en épargnant les métallisations 32 d'entrée/sortie et les chemins de découpe de la plaque en circuits unitaires. Ensuite, les protubérances 33 sont sérigraphiées au travers d'un masque métallique dont les ouvertures correspondent aux métallisations 32 des circuits 30. Ce masque de grande précision est soit usiné par laser, soit réalisé par croissance électrolytique.

Les protubérances 33 seront de préférence réalisées avec des polymères conducteurs de l'électricité qui, dans l'application aux cartes à mémoire électronique, offrent d'un point de vue mécanique un meilleur découplage du circuit intégré par rapport au corps de carte. Naturellement, pour être compatibles avec le procédé, les métallisations 32 d'entrée/sortie des circuits doivent être faites avec un métal inoxydable ou bien un métal dont l'oxyde est conducteur de l'électricité : or, titane/tungstène, argent, cuivre.

Plusieurs variantes sont à envisager selon la nature du polymère conducteur formant les protubérances :
a) le polymère est une résine époxy chargée argent qui sera polymérisée après sérigraphie.
b) le polymère est une résine époxy chargée argent réactivable, séchée après sérigraphie, et qui sera polymérisée après assemblage du circuit intégré sur le substrat isolant du module.
c) le polymère est un thermoplastique chargé argent.

A ce stade du procédé, la plaque est découpée en circuits unitaires de dimensions très faibles, de l'ordre de 1mm³, lesquels circuits unitaires sont prêts à être assemblés ou montés directement sur le substrat.

De manière automatique, chaque circuit intégré 30 muni de ses protubérances 33 est prélevé de la plaque découpée, puis retourné de manière à présenter sa face active en regard de la deuxième face d'interconnexion du substrat 10 du module. Après alignement des protubérances sur les plots de raccordement, une pression est appliquée sur le circuit 30 tandis qu'est augmentée la température de la zone du module en cours d'assemblage. Le procédé dépend des variantes choisies pour le matériau polymère conducteur des protubérances :
- dans le cas de la variante a), une sérigraphie supplémentaire sur la deuxième face d'interconnexion du substrat 10 est nécessaire, uniquement sur les plots de raccordement. Ce dépôt de résine époxy, identique à celle des protubérances, est réalisé avec un écran spécifique à chaque type de circuit intégré.
   Le dispositif chauffant de l'équipement n'est pas activé, la polymérisation de la résine époxy est faite ultérieurement après la pose du circuit.
- dans le cas de la variante b), il n'y a pas d'opération supplémentaire. Le dispositif chauffant est activé de façon à assurer le maintien du circuit, la polymérisation complète de la résine époxy est aussi faite ultérieurement,
- dans le cas de la variante c), il n'y pas non plus d'opération supplémentaire. Le dispositif chauffant est activé, la zone du substrat 10 du module en cours d'assemblage sera portée à la température de début de fusion du thermoplastique. La liaison mécanique et électrique sera réalisée pendant le refroidissement. Un autre mode de liaison est la soudure par ultra-sons.

Après ces opérations d'assemblage, une résine fluide 40 peut être dispensée à chaque pastille 30 de manière à former un scellement.

Lorsque la résine 40 est durcie, chaque position de module sur la feuille 10 de substrat est testée en fonctionnalité, les mauvaises positions étant identifiées, exactement comme les circuits intégrés sur leur plaque ("wafer").

Au moment d'être intégrés dans le corps de carte, les modules sont découpés unitairement, les mauvais étant éliminés.

## Revendications

1. Procédé de fabrication d'un ensemble de modules électroniques (100) pour cartes à mémoire électronique aptes à échanger, sans contact électrique, des informations avec un dispositif de lecture, lesdites cartes comportant, chacune, une antenne (110) de couplage avec ledit dispositif de lecture et un circuit intégré (30) connecté à ladite antenne, ledit procédé comportant les étapes suivantes :
a) réalisation, sur un substrat isolant (10) en feuille, d'une pluralité de groupes (20) régulièrement répartis de trous traversants (12), chaque groupe de trous étant associé à un module électronique (100), et lesdits trous traversants étant destinés à être remplis d'un matériau conducteur afin d'assurer la continuité électrique entre une première et une deuxième faces du substrat isolant, prévues pour recevoir respectivement, pour chaque module électronique, d'une part, des contacts électriques (13) de liaison avec un connecteur extérieur et, d'autre part, des motifs d'interconnexion (14, 15) sur lesquels le circuit intégré à protubérances est destiné à être monté,
b) une première sérigraphie consistant à réaliser lesdits contacts électriques par dépôt d'une encre conductrice sur la première face du substrat isolant en feuille, lesdits trous étant partiellement remplis de ladite encre,
c) plusieurs sérigraphies consistant à réaliser par au moins un dépôt d'une encre conductrice sur la deuxième face du substrat isolant en feuille, d'une part, lesdits motifs d'interconnexion, lesdits trous traversants étant complètement remplis par ladite encre, et, d'autre part, lesdites antennes de couplage sous forme de spire délimitées, chacune, par une première (111) et une deuxième (113) bornes d'antenne, intérieures auxdites spires,
d) montage d'un circuit intégré (30) à protubérances (33) sur les motifs d'interconnexion et les première (111) et deuxième (113) bornes intérieures d'antenne,
e) découpage de ladite feuille de substrat isolant en modules électroniques (100) formés, chacun, par l'ensemble constitué par lesdits contacts électriques (13), ladite antenne de couplage et le circuit intégré à protubérances.

2. Procédé selon la revendication 1, **caractérisé en ce que** l'étape c) comporte les étapes suivantes :
- au moins une deuxième sérigraphie, lesdites spires étant délimitées, chacune, par ladite première borne intérieure (111) d'antenne, et une borne extérieure (112) aux spires.
- une troisième sérigraphie consistant à réaliser sur chaque antenne de couplage un pont d'isolement (114) par dépôt d'une encre diélectrique sous forme d'une bande isolante (114) s'étendant sur lesdites spires entre ladite deuxième borne (113) intérieure et ladite borne extérieure (112),
- une quatrième sérigraphie consistant à réaliser un conducteur de fermeture (115) par dépôt d'une encre conductrice sous forme d'une piste (115) reliant, par l'intermédiaire dudit pont d'isolement, ladite borne extérieure (112) à ladite deuxième borne (113) intérieure d'antenne.

3. Procédé selon l'une quelconque des revendications 1 à 2, **caractérisé en ce qu**'avant l'étape de montage du circuit intégré à protubérances est intercalée une étape de dépôt, autour desdits motifs d'interconnexion et de l'antenne de couplage, d'un matériau d'assemblage (16) des modules électroniques dans des corps de carte à mémoire électronique.

4. Procédé selon la revendication 3, **caractérisé en ce que** ledit matériau d'assemblage est une résine époxy réactivable thermiquement.

5. Procédé selon la revendication 3, **caractérisé en ce que** ledit matériau d'assemblage est une colle fusible.

6. Procédé selon la revendication 3, **caractérisé en ce que** ledit matériau d'assemblage est un thermoplastique pour soudure par ultra-sons.

7. Procédé selon la revendication 3, **caractérisé en ce que** ledit matériau d'assemblage est un thermoplastique apte à favoriser la création de liaisons moléculaires entre le substrat isolant et le corps de carte lorsque les cartes à mémoire électronique sont moulées.

8. Procédé selon l'une quelconque des revendications 1 à 7, **caractérisé en ce que** ladite feuille de substrat isolant est réalisée dans un matériau thermoplastique apte à créer des liaisons moléculaires avec le corps de carte en matériau thermoplastique lorsque les cartes à mémoire électronique sont moulées.

9. Procédé selon l'une quelconque des revendications 1 à 8, **caractérisé en ce que** ladite encre conductrice est une encre polymère chargée argent, or ou or/métalloorganique.

10. Procédé selon l'une quelconque des revendications 1 à 9, **caractérisé en ce que** lesdites protubérances (33) sont en polymère conducteur.

11. Procédé selon l'une quelconque des revendications 1 à 10, **caractérisé en ce que** ladite encre diélectrique est une encre polymère chargée alumine.

## Patentansprüche

1. Herstellungsverfahren eines Aufbaus von Elektronikmodulen (100) für Karten mit elektronischem Speicher, die geeignet sind, ohne elektrischen Kontakt Informationen mit einer Lesevorrichtung auszutauschen, wobei besagte Karten jede eine Kopplungsantenne (110) mit besagter Lesevorrichtung und einen integrierten Schaltkreis (30) umfassen, der an besagte Antenne angeschlossen ist, wobei besagtes Verfahren die folgenden Schritte umfaßt:
a) Realisierung einer Vielzahl von regelmäßig verteilten Gruppen (20) durchgehender Löcher (12) auf einem isolierenden Substrat (10) aus Folie, wobei jede Lochgruppe einem elektrischen Modul (100) zugeordnet ist, und besagte durchgehende Löcher dazu bestimmt sind, mit einem leitenden Material ausgefüllt zu werden, um die elektrische Kontinuität zwischen einer ersten und einer zweiten Seite des isolierenden Substrats zu gewährleisten, die dazu vorgesehen sind, jeweils für jedes elektronische Modul einerseits die elektrischen Kontakte (13) zur Verbindung mit einem äußeren Verbinder und andererseits Zusammenschaltungsmuster (14, 15) aufzunehmen, auf die der integrierte Schaltkreis mit Protuberanzen aufgebaut werden soll.
b) eine erste Serigraphie, darin bestehend, besagte elektrische Kontakte durch Ablagerung einer leitenden Druckfarbe auf der ersten Seite des isolierenden Substrats aus Folie zu realisieren, wobei besagte Löcher teilweise durch besagte Druckfarbe gefüllt sind,
c) mehrere Serigraphien, darin bestehend, durch wenigstens eine Ablagerung einer leitenden Druckfarbe auf der zweiten Seite des isolierenden Substrats aus Folie einerseits besagte Zusammenschaltungsmuster, wobei besagte durchgehende Löcher vollständig von besagter Druckfarbe ausgefüllt sind, und andererseits besagte Kopplungsantennen in Form von begrenzten Windungen zu realisieren, jede durch eine innen zu besagten Windungen erste (111) und eine zweite (113) Antennenklemme.
d) Aufbau eines integrierten Schaltkreises (30) mit Protuberanz (33) auf den Zusammenschaltungsmustern und den ersten (111) und zweiten (113) inneren Antennenklemmen,
e) Zuschnitt besagter Folie isolierenden Substrats in elektronische Module (100), die jedes durch den Aufbau geformt werden, der durch besagte elektrische Kontakte (13), besagte Kopplungsantenne und den integrierten Schaltkreis mit Protuberanz gebildet werden.

2. Verfahren gemäß Anspruch 1, **dadurch gekennzeichnet**, daß der Schritt c) folgende Schritte umfaßt:
- wenigstens eine zweite Serigraphie, wobei besagte Windungen jede durch besagte erste innere Antennenklemme (111) und eine äußere Klemme (112) mit Windungen begrenzt sind,
- eine dritte Serigraphie, bestehend in der Realisierung einer Isolationsbrücke (114) auf jeder Kopplungsantenne durch Ablagerung einer dielektrischen Druckfarbe in Form eines Isolierbandes (114), das sich über besagte Windungen zwischen besagter zweiter inneren Klemme (113) und besagter äußerer Klemme (112) erstreckt,
- eine vierte Serigraphie, bestehend in der Realisierung eines Schließverbinders (115) durch Ablagerung einer leitenden Druckfarbe in Form einer Spur (115), die mittels besagter Isolationsbrücke besagte äußere Klemme (112) mit besagter innerer zweiter Antennenklemme (113) verbindet.

3. Verfahren gemäß Anspruch 1 bis 2, **dadurch gekennzeichnet**, daß vor dem Schritt des Aufbaus des integrierten Schaltkreises mit Protuberanz ein Ablagerungsschritt um den besagte Zusammenschaltungsmuster und die Kopplungsantenne eines Zusammenbaumaterials (16) der elektronischen Module im Körper der elektronischen Speicherkarte zwischengeschaltet ist.

4. Verfahren gemäß Anspruch 3, **dadurch gekennzeichnet**, daß besagtes Zusammenbaumaterial aus thermisch reaktivierbarem Epoxydharz ist.

5. Verfahren gemäß Anspruch 3, **dadurch gekennzeichnet**, daß besagtes Zusammenbaumaterial ein schmelzbarer Klebstoff ist.

6. Verfahren gemäß Anspruch 3, **dadurch gekennzeichnet**, daß besagtes Zusammenbaumaterial ein Thermoplastik zum Schweißen per Ultraschall ist.

7. Verfahren gemäß Anspruch 3, **dadurch gekennzeichnet**, daß besagtes Zusammenbaumaterial ein Thermoplastik ist, das geeignet ist, die Kreation von molekularen Verbindungen zwischen dem isolierenden Substrat und dem Kartenkörper zu fördern, wenn die Karten mit elektronischem Speicher in Form gegossen werden.

8. Verfahren gemäß Anspruch 1 bis 7, **dadurch gekennzeichnet**, daß besagte Folie isolierenden Substrats in einem thermoplastischen Material realisiert ist, das geeignet ist, molekulare Verbindungen mit dem Kartenkörper aus thermoplastischem Material zu kreieren, wenn die Karten mit elektronischem Speicher in Form gegossen werden.

9. Verfahren gemäß Anspruch 1 bis 8, **dadurch gekennzeichnet**, daß besagte leitende Druckfarbe eine mit Silber, Gold oder metallorganischem Gold geladene Polymerdruckfarbe ist.

10. Verfahren gemäß Anspruch 1 bis 9, **dadurch gekennzeichnet**, daß besagte Protuberanzen (33) aus leitendem Polymer sind.

11. Verfahren gemäß Anspruch 1 bis 10, **dadurch gekennzeichnet**, daß besagte dielektrische Druckfarbe eine mit Aluminiumoxid geladene Polymerdruckfarbe ist.

## Claims

1. A method of making an assembly of electronic modules (100) for electronic memory cards adapted to exchange information with a reader device without electrical contact, said cards each comprising an antenna (110) for coupling it to said reader device and an integrated circuit (30) connected to said antenna, said method including the following steps:
a) forming in an insulative substrate sheet (10) a plurality of regularly distributed groups (20) of through-holes (12), each group of holes being associated with one electronic module (100), and said through-holes being adapted to be filled with a conductive material to assure electrical continuity between first and second faces of the insulative substrate, respectively adapted to receive, for each electronic module, firstly electrical contacts (13) for connection to an external connector, and secondly interconnection patterns (14, 15) on which the integrated circuit with protuberances is to be mounted,
b) a first screenprinting operation consisting in forming said electrical contacts by depositing a conductive ink on the first face of the insulative substrate sheet, said holes being partly filled with said ink,
c) a plurality of screenprinting operations consisting in forming by at least one operation of depositing a conductive ink on the second face of the insulative substrate sheet, firstly said interconnection patterns, said through-holes being completely filled by said ink, and secondly said coupling antennas in the form of turns each defined by first and second antenna terminals (111, 113) inside said turns,
d) mounting an integrated circuit (30) with protuberances (33) on the interconnection patterns and the inner first and second antenna terminals (111, 113), and
e) cutting said insulative substrate sheet into electronic modules (100) each formed by the combination of said electrical contacts (13), said coupling antenna and the integrated circuit with protuberances.

2. A method according to claim 4, **characterized in that** step c) includes the following steps:
- at least one second screenprinting operation, said turns each being defined by said inner first antenna terminal (111) and a terminal (112) outside the turns,
- a third screenprinting operation consisting in forming an insulative bridge (114) over each coupling antenna by depositing a dielectric ink in the form of an insulative strip (114) extending across said turns between said inner second terminal (113) and said outer terminal (112), and
- a fourth screenprinting operation consisting in forming a closure conductor (115) by depositing a conductive ink in the form of a track (115) connecting said outer terminal (112) to said inner second antenna terminal (113) via said insulative bridge.

3. A method according to any one of claims 1 to 2, **characterized in that** the step of mounting the integrated circuit with protuberances is preceded by a step of depositing a material (16) for assembling the electronic modules into the electronic memory card bodies around said interconnection patterns and the coupling antenna.

4. A method according to claim 3, **characterized in that** said assembly material is an epoxy resin that can be reactivated thermally.

5. A method according to claim 3, **characterized in that** said assembly material is a hot melt glue.

6. A method according to claim 3, **characterized in that** said assembly material is a thermoplastics material for ultrasound welding.

7. A method according to claim 3, **characterized in that** said assembly material is a thermoplastics material which encourages the creation of molecular bonds between the insulative substrate and the card body when the electronic memory cards are molded.

8. A method according to any one of claims 1 to 7, **characterized in that** said insulative substrate sheet is made of a thermoplastics material which encourages the creation of molecular bonds with the thermoplastics material card body when the electronic memory cards are molded.

9. A method according to any one of claims 1 to 8, **characterized in that** said conductive ink is a polymer ink charged with silver, gold, or gold/organometallic compounds.

10. A method according to any one of claims 1 to 9, **characterized in that** said protuberances (33) are made of conductive polymer.

11. A method according to any one of claims 1 to 10, **characterized in that** said dielectric ink is a polymer ink charged with alumina.
